# EUROPEAN PATENT SPECIFICATION

(11) **EP 3 407 074 B1**
(45) Date of publication and mention of the grant of the patent: **15.06.2022**
(21) Application number: 18168703.9
(22) Date of filing: 23.04.2018
(51) Int. Cl.: G01R 15/06, G01R 19/155

(54) **A DEVICE AND METHOD FOR DETECTING A TRAP VOLTAGE OF A CAPACITOR POTENTIAL TRANSFORMER**
VORRICHTUNG UND VERFAHREN ZUR DETEKTION EINER FANGSPANNUNG EINES KONDENSATOR-POTENZIALWANDLERS
DISPOSITIF ET PROCÉDÉ DE DÉTECTION D'UNE TENSION DE PIÈGE D'UN TRANSFORMATEUR DE POTENTIEL DE CONDENSATEUR

(30) Priority: 26.04.2017 CN 201710284197
(43) Date of publication of application: 28.11.2018
(73) Proprietor: Siemens Aktiengesellschaft, 80333 München (DE)
(72) Inventor: DENG, Su Bi, Nanjing, Jiangsu 210012 (CN); LIU, Yu Hong, Nanjing, Jiangsu 211100 (CN)
(74) Representative: Isarpatent

(56) References cited:
- DE-A1- 19 648 230
- US-A- 4 437 134
- US-A1- 2013 234 731

## Description

### Technical Field

The present invention generally relates to the field of electric power automation, and in particular relates to the detection of a primary high-voltage signal on the secondary side (low-voltage side) by use of a potential transformer.

### Background Art

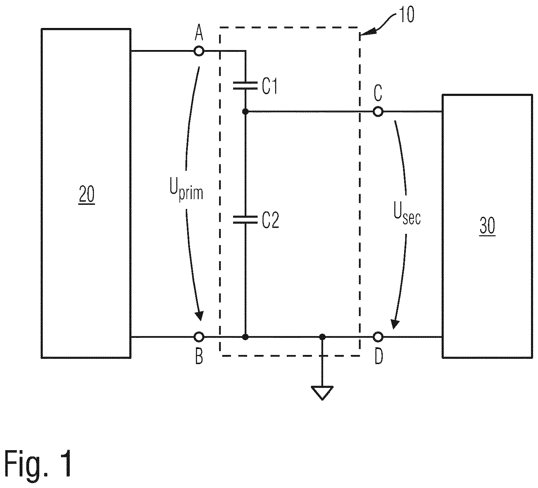

A capacitor potential transformer (CPT) is usually used in a high-voltage power grid to monitor voltage signals on the primary side (high-voltage side) in the power grid. Figure 1 is a schematic diagram for a typical capacitor potential transformer. As shown in Figure 1, the CPT (10) is connected between the primary equipment (20) and the secondary equipment (30) in a power system and is used to convert an obtained primary high voltage (Uprim) into a secondary low voltage (Usec) and send the secondary low voltage to the secondary equipment (30) for further analysis. Here, the primary equipment (20) is the equipment used to produce and utilize electrical power energy, for example, high-voltage power transmission line, high-voltage switch, transformer, and electric reactor. The secondary equipment (30) is the equipment mainly used for monitoring, measurement, control protection, or regulation in the power system, for example, merging unit and relay protection unit.

In Figure 1, the input ends (A and B) of the CPT (10) are connected to the primary equipment (20) to obtain a primary high voltage (Uprim) from high-voltage grid lines, for example. The CPT (10) comprises two inductive capacitors (C1 and C2) connected in series. The capacitance of the capacitors (C1 and C2) can be a magnitude of nF or pF, and the capacitance ratio can be determined according to the ratio between Uprim and Usec, for example. Output ends (C and D) are led out of the two ends of the capacitor (C2) of the CPT (10). For example, if the primary voltage (Uprim) connected to input ends (A and B) is 110 kV, then the secondary voltage (Usec) between the output ends (C and D) can be up to about 100 V. The secondary voltage (Usec) is output to the secondary equipment (30) for analysis and processing. The CPT is also known as non-contact potential transformer.

In the CPT (10) shown in Figure 1, Uprim is generally a sine AC signal, and Usec varies with Uprim. However, owing to the existence of the inductive capacitors, Usec will lag behind Uprim. The primary equipment (20) may be cut off in a plurality of cases. For example, in the case of a failure, a power failure may suddenly happen to the primary equipment at a point of time when Uprim≠0 so that Uprim is transiently set to 0. In this case, Usec cannot transiently change to 0 together with Uprim owing to the existence of the inductive capacitors. On the contrary, trap charges will be accumulated on the inductive capacitors (C1 and C2) . This makes Usec remain a DC voltage, also known as trap voltage (Vtrap) . For this reason, trap charge is also called trap voltage (Vtrap) . If there is no charge release circuit in the primary equipment (20), the trap voltage (Vtrap) will remain until power is supplied to the primary equipment (20) again. Since the trap voltage is exerted on the output ends (C and D), when power is supplied to the primary equipment (20) again, the secondary equipment (30) will probably sense a wrong Usec and thus will consider by mistake that a failure happens and then will take protection actions. It can be seen that the existence of a trap voltage is very dangerous. It is necessary to detect when a trap voltage occurs and enable the secondary equipment (30) to track the correct primary voltage (Uprim) when detecting a trap voltage.

A common method for detecting a trap voltage is realized by the software in the secondary equipment. In a prior solution, a finite impulse response (FIR) filter based on discrete Fourier transform (DFT) is used to perform discrete Fourier transform for a sampled signal to calculate the real component and imaginary component of the phase of the sampled signal. On the basis of the phase, the change of gradient and amplitude of the phase between time point k and time point k-1 is then calculated. If the change of gradient of the phase falls within the range of a preset threshold (for example, 20% of the phase gradient at a nominal frequency), it indicates that trap charges occur. If the change of amplitude of the phase exceeds a preset threshold (for example, 0.5% of a nominal voltage), it indicates that the trap voltage (Vtrap) will increase.

### Summary of the Invention

One objective of the present invention is to provide a device and method for detecting a trap voltage of a CPT. The device and method can accurately detect whether a trap charge occurs, without any incorrect determination.

According to one embodiment of the present invention, the present invention provides a method for detecting a trap voltage of a CPT, wherein said potential transformer is connected between the primary equipment and the secondary equipment. Said method comprises: setting an initial state of an indicator, wherein said indicator has two states, one of which indicates that a primary voltage is an AC voltage, and the other of which indicates that said primary voltage is a DC voltage; obtaining a detection value on the primary side of said potential transformer; obtaining a differential value of said detection value; determining whether a trap voltage occurs to said potential transformer according to said detection value, said differential value, and said indicator.

An indicator which indicates the state on the primary side is introduced in the method provided in the present invention, and thus it can accurately be determined whether a trap voltage occurs . In addition, the determination method can be realized in the secondary equipment and the cost is low. Furthermore, since no DFT calculation is required in the method provided in the present invention, the CPU occupancy percentage is low and thus a low-end CPU can be selected.

Preferably, said determination step comprises: if said indicator is in the AC state, and both said detection value and said differential value are less than a preset first threshold, indicating that said potential transformer starts to enter a trap state; if said indicator is in the DC state, and both said detection value and said differential value are greater than or equal to said preset first threshold, indicating that said potential transformer starts to recover from the trap state to the normal state.

In the method provided in the present invention, since a trap voltage is determined according to the jumping of the detection value on the secondary side and the indicator indicating the state on the primary side, not only whether a trap voltage occurs can accurately be determined, but also when a trap voltage is removed can be determined.

More preferably, said method further comprises: setting the initial values of a trap voltage counter and a recovery counter to 0; said determination step comprises: if said indicator is in the AC state, and both said detection value and said differential value are less than a preset first threshold, incrementing said trap voltage counter by 1; if said indicator is in the DC state, and both said detection value and said differential value are greater than or equal to said preset first threshold, incrementing said recovery counter by 1; if said trap voltage counter is greater than a second threshold, which indicates that the potential transformer enters a trap voltage state, switching the state of the indicator from the AC state to the DC state; if said recovery counter is greater than a third threshold, which indicates that the trap voltage state of the potential transformer ends, switching the state of the indicator from the DC state to the AC state. Preferably, said second threshold is about 1/4 to 3/4 of a cycle of said primary AC electrical signal. More preferably, said third threshold is about 1/80 to 1/2 of a cycle of said primary AC electrical signal.

In the above method provided in the present invention, a trap voltage counter and a recovery counter are introduced to help to determine a trap voltage. The use of the trap voltage counter and the recovery counter can prevent any incorrect determination caused by accidental signal burrs, and thus a trap voltage determination is more accurate.

According to another embodiment of the present invention, the present invention provides a device for detecting a trap voltage of a CTP. The device comprises: input ends connected to the output ends on the secondary side of said potential transformer; an A/D converter sampling the signals input from said input ends to obtain a detection value on the secondary side of said potential transformer; a storage unit storing an indicator, wherein said indicator has two states, one of which indicates that a primary voltage of said potential transformer is an AC voltage, and the other of which indicates that said primary voltage of said potential transformer is a DC voltage; a calculation unit connected to said A/D converter and said storage unit and configured to obtain a secondary detection value of said potential transformer and a differential value of said detection value, and determine whether a trap voltage occurs according to said detection value, said differential value, and said indicator.

Preferably, said calculation unit is configured to determine that said potential transformer starts to enter a trap state if said indicator is in the AC state, and both said detection value and said differential value are less than a preset first threshold, and determine that said potential transformer starts to recover from the trap state to the normal state if said indicator is in the DC state, and both said detection value and said differential value are greater than or equal to said preset first threshold.

More preferably, said storage unit further stores a trap voltage counter and a recovery counter; said calculation unit is further configured to increment said trap voltage counter by 1 if said indicator is in the AC state and both said detection value and said differential value are less than a preset first threshold, increment said recovery counter by 1 if said indicator is in the DC state and both said detection value and said differential value are greater than or equal to said preset first threshold, switch the state of the indicator from the AC state to the DC state if said trap voltage counter is greater than a second threshold, which indicates that the potential transformer enters a trap voltage state, and switch the state of the indicator from the DC state to the AC state if said recovery counter is greater than a third threshold, which indicates that the trap voltage state of the potential transformer ends.

The following will describe preferred embodiments in combination with the drawings in a clear and understandable way to further describe the above-mentioned characteristics, technical characteristics, advantages, and implementation mode of the device.

### Brief Description of the Drawings

The following drawings are used to give an exemplary description and explanation of the present invention, but are not used to limit the scope of the present invention.
Figure 1 shows the structure of an exemplary CPT.
Figure 2A to Figure 2C show the voltage oscillograms of three samples in a trap voltage state.
Figure 3 is a flowchart of the method for detecting a trap voltage in one embodiment of the present invention.
Figure 4A to Figure 4D show the detection results of the method for detecting a trap voltage in one embodiment of the present invention only for exemplary purposes.
Figure 5 is a schematic diagram for the device for detecting a trap voltage in one embodiment of the present invention.

Description of reference numbers in the drawings:
10: Capacitor potential transformer 20: Primary equipment 30: Secondary equipment
C1 and C2: Capacitors
32: A/D converter 34: Storage unit 36: Calculation unit

### Detailed Description of the Invention

To help you to understand the technical characteristics, objective, and effect of the present invention more clearly, the following describes the specific implementation mode of the present invention by reference to the drawings in which the same reference number represents a component whose structure is the same or whose structure is similar but function is the same.

In this document, "exemplary" means "acting as an instance, example, or illustration", and any illustration or implementation mode described in this document should not be interpreted as a more preferred or advantageous technical solution.

For the simplicity of the drawings, only the parts relating to the present invention are shown for an exemplary purpose and they do not represent the actual structure of a product. In addition, only one of the components which have the same structure or function is depicted or marked for an exemplary purpose in some drawings so that the drawings are simplified to help you to understand.

In this document, "one" not only represents "only one", but also may represent "more than one". In this document, "first" and "second" are used only to distinguish from each other, but do not represent their importance or sequence.

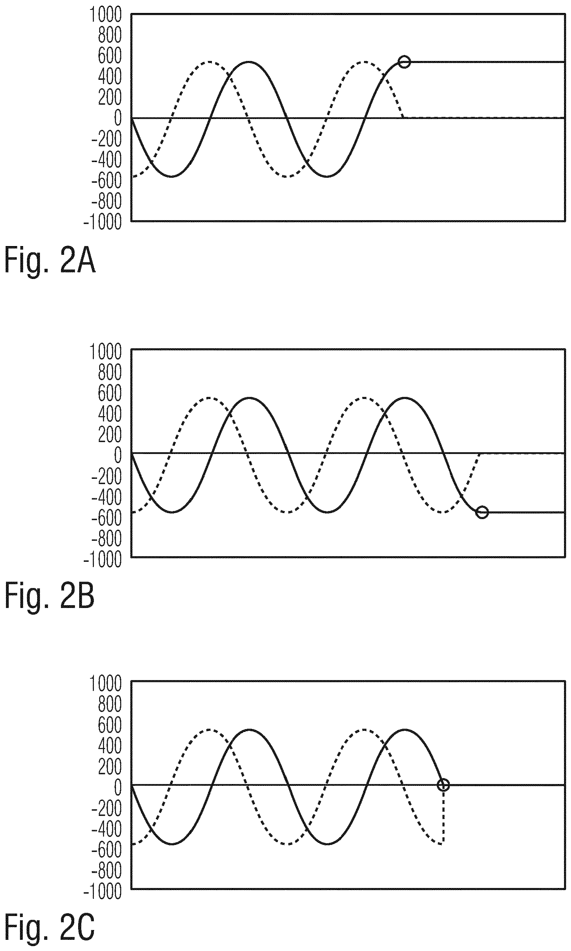

Figure 2A to Figure 2C show three exemplary AC power failure cases on the primary side of the CPT (10). In Figure 2A to Figure 2C, the solid line represents the detected primary voltage (Uprim) and the dotted line represents the secondary voltage (Usec), namely, detection value (Vin) detected in the secondary equipment (30). The primary voltage (Uprim) is high-voltage AC and is in the shape of sine waves. Owing to the existence of capacitors (C1 and C2) in the CPT (10), the detection value (Vin) detected in the secondary equipment (30) lags behind Uprim. In the example in Figure 2, Vin lags about 1/4 of a cycle behind Uprim.

In Figure 2A, when Uprim reaches a positive maximum, a power failure (circled in the figure) occurs to the primary equipment (20) because of a fault. In this case, if the primary equipment has no current bleeder circuit, the voltage between the two ends of the capacitor is the DC voltage in the positive maximum position of Uprim. At this time, Vin on the secondary side approaches zero because it lags 1/4 of a cycle behind Uprim, and in addition, Vin remains zero because there is no AC input.

In Figure 2B, when Uprim reaches a minimum, a power failure (circled in the figure) occurs to the primary equipment (20) because of a fault. In this case, if the primary equipment has no current bleeder circuit, the voltage between the two ends of the capacitor is the DC voltage in the minimum (negative maximum) position of Uprim. At this time, Vin on the secondary side approaches zero because it lags 1/4 of a cycle behind Uprim, and in addition, Vin remains zero because there is no AC input.

In Figure 2C, when Uprim reaches zero, a power failure (circled in the figure) occurs to the primary equipment (20) because of a fault. In this case, the voltage between the two ends of the capacitor is 0 VDC. At this time, Vin on the secondary side approaches the minimum (negative maximum) because it lags 1/4 of a cycle behind Uprim, and Vin immediately changes to zero, however, because there is no AC input.

In the examples in Figure 2A and Figure 2B, the voltage (Uprim) detected at the two input ends (A and B) cannot reflect the real primary voltage, and thus a trap voltage occurs. In the example in Figure 2C, Uprim is consistent with the actual primary AC voltage oscillogram, and thus no trap voltage occurs. From Figure 2A to 2C, it can be seen that the detection value (Vin) detected in the secondary equipment (30) approaches zero and the differential value also approaches zero, no matter whether a trap voltage occurs. Therefore, it is difficult to use the prior DFT and differential comparison methods to determine whether a trap voltage occurs.

In view of the above-mentioned problem, the inventor of the present invention proposed a method for detecting a trap voltage of a capacitor potential transformer. In short, the method comprises: setting an indicator (Fprim) to indicate the state of a primary voltage and then determining whether a trap voltage occurs according to a detection value (Vin) detected in the secondary equipment, the differential value (Vd) of said detection value (Vin), and said indicator (Fprim). Here, the indicator (Fprim) has two states: AC and DC, which respectively represent a state of a primary AC voltage. The AC state indicates that the primary AC voltage is normal, and the DC state indicates that the primary AC voltage is DC/fails. The introduction of the indicator, equivalent to the introduction of a primary AC state value, helps to accurately determine whether a trap voltage occurs.

To be specific, if the indicator (Fprim) is in the AC state, and both the detection value (Vin) and the differential value (Vd) are less than a preset first threshold (TH1), it indicates that the potential transformer enters a trap state. If the indicator (Fprim) is in the DC state, and both the detection value (Vin) and the differential value (Vd) are greater than or equal to the first threshold (TH1), it indicates that the trap voltage state ends.

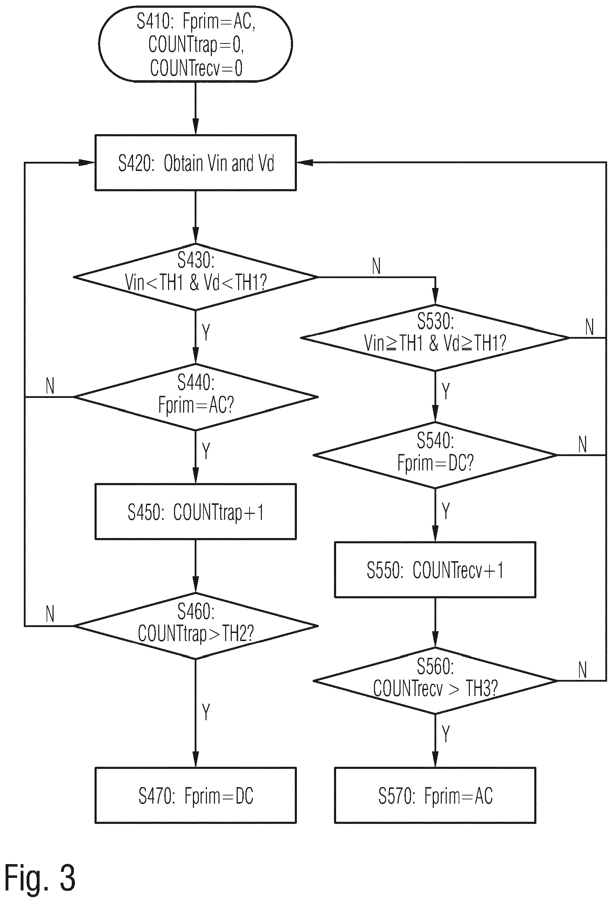

Figure 3 is a flowchart of the above-mentioned method in one embodiment of the present invention. As shown in Figure 3, the flowchart starts with step S410. In step S410, initialize three parameters, namely, set the indicator (Fprim) to the AC state (namely, the primary side works normally), and set COUNTtrap=0 and COUNTrecv=0. The two counters are used to monitor the change process of the trap voltage state and can prevent state switching caused by a transient instability. In step S420, obtain a detection value (Vin) detected on the secondary side and a differential value (Vd) of Vin. Then, make a determination in step S430.

In step S430, determine whether the detection value (Vin) and said differential value (Vd) are less than a preset first threshold (TH1). If yes, go to step S440. Otherwise, go to step S530. In step S440, further determine whether the indicator (Fprim) is in the AC state. If yes, go to step S450 and increment the trap voltage counter (COUNTtrap) by 1. Otherwise, return to step S420. In step S460, further determine whether the trap voltage counter (COUNTtrap) is greater than a second threshold (TH2). If yes, go to step S470 and change the indicator (Fprim) from AC to DC, which indicates that the potential transformer currently has entered the trap voltage state.

In step S530, further determine whether the detection value (Vin) and said differential value (Vd) are greater than a preset first threshold (TH1). If yes, go to step S540. Otherwise, return to step S420 to obtain a new Vin and Vd. In step S540, further determine whether the indicator (Fprim) is in the DC state. If yes, go to step S550 and increment the recovery counter (COUNTrecv) by 1. Otherwise, return to step S420. In step S560, further determine whether the recovery counter (COUNTrecv) is greater than a third threshold (TH3) . If yes, go to step S570 and change the indicator (Fprim) from DC to AC, which indicates that the trap voltage state currently has ended and the potential transformer enters a recovery process.

Figure 3 shows the flow of one method only for an exemplary purpose. In practical applications, the flow of the above-mentioned method can vary, depending on the practical requirements and the procedure requirements. For example, the sequence of the step of determining Vin and Vd and the step of determining the state of the indicator can be reversed. The step of determining whether Vin and Vd are greater or less than a threshold can also be performed in a reversed sequence. In addition, steps S430 to S470 and steps S530 to S570 can be performed in two independent threads.

In addition, preferably, the second threshold (TH2) in Figure 3 is equivalent to 1/4 to 3/4 of a cycle of a primary AC electrical signal. More preferably, the third threshold (TH3) can be so selected that it is approximately equivalent to 1 to 40 sampling points of the secondary equipment, namely, 1/80 to 1/2 of a cycle.

The adoption of the trap voltage counter and the recovery counter can avoid a state change caused by accidental signal burrs.

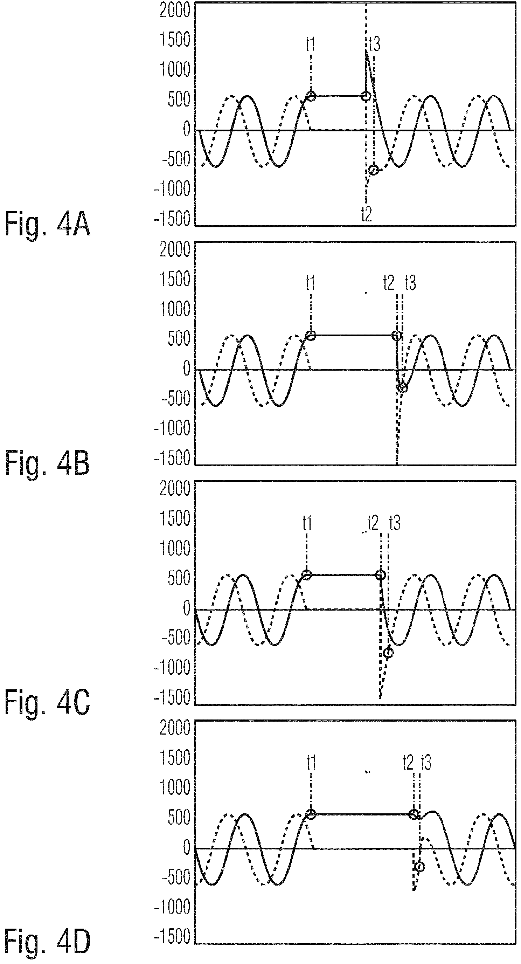

Figure 4A and Figure 4B show four cases where a trap voltage is caused by a power failure of the primary equipment. The following particularly describes the operation process of the method shown in Figure 3 in combination with the actual condition shown in Figure 4. The solid lines in Figure 4 represent actual voltages on the primary side, and the dotted lines represent detection values (Vin) detected in the secondary equipment.

Figure 4A shows the case where a power failure occurs to the primary equipment at the maximum of the sine signal and the power supply is recovered at the phase of the highest point of the sine signal. As shown in Figure 4A, a power failure occurs to the primary equipment at the maximum of the AC voltage (Uprim = Max) at time point t1. At this time, Fprim=AC, COUNTtrap=0, and COUNTrecv=0, just like the initial settings. As described previously, Vin reaches zero and remains in the DC state. In the next sampling values, Vin and Vd roughly remain zero. Thus, according to the flow shown in Figure 3, COUNTtrap is incremented by 1 in each step from step S430 to step S450. If COUNTtrap is greater than the second threshold (TH2), Fprim is switched from AC to DC and remains in the DC state. This indicates that the potential transformer enters a trap voltage state. Here, if there are 80 sampling points in each sine wave period, TH2 is preferably 60. As shown in Figure 4A, the power supply to the primary equipment is recovered at the phase of the peak point of the sine signal at time point t2. At this time, a maximum is exerted between the two ends of the capacitor, where the voltage originally remains Uprim=Max, and thus the voltage between the two ends of the capacitor is twice the maximum, namely, Uprim=2Max. The change leads to a maximum value of the detection value (Vin), and the differential value (Vd) of Vin also increases accordingly. Now, Fprim=DC and Vin>TH1&Vd>TH1, and thus COUNTrecv is incremented by 1 in each step from step S530 to step S550 according to the flow shown in Figure 3. Starting from time point t2, the primary equipment exerts sine signals on the capacitor and fluctuating voltage signals can be detected on the secondary side. Steps S420, and S530 to S560 are repeated until COUNTrecv is greater than a third threshold (TH3) (namely, a plurality of sampling points after t2, for example, t3) . Then in step S570, Fprim is switched from DC to AC, that is to say, the trap voltage state ends and the primary AC voltage is recovered to be normal. Here, TH3 is preferably 1 to 40 sampling points and is approximately equivalent to 1/80 to 1/2 of a cycle of an AC electrical signal, and more preferably TH3 = 2 sampling points, namely, 1/40 of a cycle.

In this way, the start and end of a trap voltage state can accurately be determined by use of the flow shown in Figure 3, without complex DFT calculations.

Figure 4B shows the case where a power failure occurs to the primary equipment at the maximum of the sine signal and the power supply is recovered at the phase of the lowest point of the sine signal. As shown in Figure 4B, a power failure occurs to the primary equipment at the maximum of the AC voltage (Uprim = Max) at time point t1. Thus, according to the flow shown in Figure 3, COUNTtrap is incremented by 1 in each step from step S430 to step S450. If COUNTtrap is greater than the second threshold (TH2) (namely, a plurality of sampling points after t1), Fprim is switched from AC to DC and remains in the DC state. This indicates that the potential transformer enters a trap voltage state. As shown in Figure 4B, the power supply to the primary equipment is recovered at the phase of the lowest point of the sine signal at time point t2. At this time, a negative maximum is exerted between the two ends of the capacitor, where the voltage originally remains Uprim=Max, and thus the voltage between the two ends of the capacitor reaches zero, namely, Uprim=0. The change leads to a negative maximum value of the detection value (Vin), and the differential value (Vd) of Vin also increases accordingly. Now, Fprim=DC and Vin>TH1&Vd>TH1, and thus COUNTrecv is incremented by 1 in each step from step S530 to step S550 according to the flow shown in Figure 3. Starting from time point t2, the primary equipment exerts sine signals on the capacitor and jumping voltage signals can be detected on the secondary side. Steps S420, and S530 to S560 are repeated until COUNTrecv is greater than the third threshold (TH3) (namely, a plurality of sampling points after t2, for example, t3). Then in step S570, Fprim is switched from DC to AC, that is to say, the trap voltage state ends and the primary AC voltage is recovered to be normal.

Figure 4C and Figure 4D respectively show the case where a power failure occurs to the primary equipment at the maximum of the sine signal and the power supply is recovered at the phase of the zero value of the sine signal. The phase after power supply recovery in Figure 4C is a positive voltage exerted after the zero point, and the phase after power supply recovery in Figure 4D is a negative voltage exerted after the zero point. Similar to Figure 4A and Figure 4b, a power failure occurs to the primary equipment at time point t1, and the secondary equipment can determine that the potential transformer enters a trap voltage state according to steps S420 to S470 shown in Figure 3. After the power supply to the primary equipment is recovered at time point t2, the secondary equipment detects the jumping of Vin and Vd and determines that the trap voltage state ends at time point t3 according to steps S420, and S530 to S570 shown in Figure 3. The determination processes in Figure 4C and Figure 4D are the same as the previous determination processes, and will not be described again here.

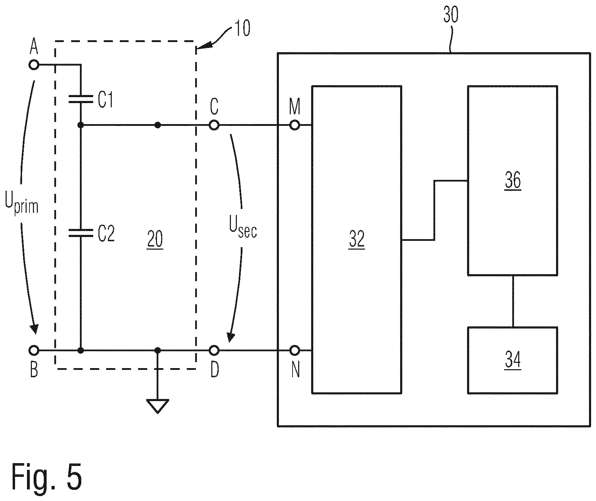

Figure 5 shows a device (30) for detecting a trap voltage of a CPT in one embodiment of the present invention. The device (30) comprises input ends (M and N), an A/D converter (32), a storage unit (34), and a calculation unit (36). Input ends (M, N) are connected to the output end (C and D) on the secondary side of the potential transformer (10). The A/D converter (32) samples the signal Usec input from the input ends (M and N) to obtain a detection value (Vin) on the secondary side of the potential transformer. The storage unit (34) stores an indicator (Fprim), wherein said indicator (Fprim) has two states, one of which indicates that a primary voltage of said potential transformer is an AC voltage, and the other of which indicates that said primary voltage of said potential transformer is a DC voltage. The calculation unit (36) is connected to the A/D converter (32) and the storage unit (34). The calculation unit (36) is configured to obtain a detection value (Vin) from the A/D converter (32) and calculate or obtain the differential value (Vd) of the detection value (Vin). In addition, the calculation unit (36) determines whether a trap voltage occurs according to the detection value (Vin), the differential value (Vd), and the indicator (Fprim).

To be specific, the calculation unit (36) is further configured to determine that the potential transformer enters a trap state if said indicator (Fprim) is in the AC state, and both the detection value (Vin) and the differential value (Vd) are less than a preset first threshold (TH1), and determine that the potential transformer has been recovered from the trap state to the normal state if the indicator (Fprim) is in the DC state, and both the detection value (Vin) and the differential value (Vd) are greater than or equal to said preset first threshold (TH1).

Preferably, the storage unit (34) further stores a trap voltage counter (COUNTtrap) and a recovery counter (COUNTrecv). The calculation unit (36) is further configured to increment the trap voltage counter (COUNTtrap) by 1 if said indicator (Fprim) is in the AC state and both the detection value (Vin) and the differential value (Vd) are less than a preset first threshold (TH1) ; increment the recovery counter (COUNTrecv) by 1 if the indicator (Fprim) is in the DC state and both the detection value (Vin) and the differential value (Vd) are greater than or equal to said preset first threshold (TH1); determines that the potential transformer enters a trap voltage state and switch the state of the indicator (Fprim) from the AC state to the DC state if the trap voltage counter (COUNTtrap) is greater than a second threshold (TH2); and determine that the trap voltage state of the potential transformer ends and switch the state of the indicator (Fprim) from the DC state to the AC state if the recovery counter (COUNTrecv) is greater than a third threshold (TH3).

In the example shown in Figure 5, the A/D converter is independent of the calculation unit. Optionally, the A/D converter and the calculation unit can be integrated into a unit, for example, a CPU having an A/D interface.

## Claims

1. A method for detecting a trap voltage of a capacitor potential transformer, wherein said potential transformer is connected between primary equipment and secondary equipment, wherein said method comprises:
setting an initial state of an indicator (Fprim), wherein said indicator (Fprim) has two states, one of which indicates that a primary voltage is an AC voltage, and the other of which indicates that said primary voltage is a DC voltage;
obtaining a detection value on the secondary side of said potential transformer;
obtaining a differential value of said detection value ; and
determining whether a trap voltage occurs according to said detection value, said differential value, and said indicator (Fprim).

2. The method as claimed in claim 1, wherein said determination step comprises:
if said indicator (Fprim) is in the AC state, and both said detection value (Vin) and said differential value are less than a preset first threshold (TH1), indicating that said potential transformer starts to enter a trap state;
if said indicator (Fprim) is in the DC state, and both said detection value and said differential value are greater than or equal to said preset first threshold (TH1), indicating that said potential transformer starts to recover from the trap state to the normal state.

3. The method as claimed in claim 1, further comprising:
setting the initial values of a trap voltage counter (COUNTtrap) and a recovery counter (COUNTrecv) to 0;
wherein said determination step comprises:
if said indicator (Fprim) is in the AC state, and both said detection value and said differential value are less than a preset first threshold (TH1), incrementing said trap voltage counter (COUNTtrap) by 1;
if said indicator (Fprim) is in the DC state, and both said detection value (Vin) and said differential value are greater than or equal to said preset first threshold (TH1), incrementing said recovery counter (COUNTrecv) by 1;
if said trap voltage counter (COUNTtrap) is greater than a second threshold (TH2), which indicates that the potential transformer enters a trap voltage state, switching the state of the indicator (Fprim) from the AC state to the DC state;
if said recovery counter (COUNTrecv) is greater than a third threshold (TH3), which indicates that the trap voltage state of the potential transformer ends, switching the state of the indicator (Fprim) from the DC state to the AC state.

4. The method as claimed in claim 3, wherein said second threshold (TH2) corresponds to about 1/4 to 3/4 of a cycle of said primary AC electrical signal.

5. The method as claimed in claim 3, wherein said third threshold (TH3) corresponds to about 1/80 to 1/2 of a cycle of said primary AC electrical signal.

6. A device (30) for detecting a trap voltage of a capacitor potential transformer, the device (30) comprising:
input ends (M and N), connected to the output ends (C and D) on the secondary side of said potential transformer;
an analog/digital (A/D) converter (32), sampling the signals input from said input ends (M and N) to obtain a detection value on the secondary side of said potential transformer;
a storage unit (34), storing an indicator (Fprim), wherein said indicator (Fprim) has two states, one of which indicates that a primary voltage of said potential transformer is an AC voltage, and the other of which indicates that said primary voltage of said potential transformer is a DC voltage;
a calculation unit (36), connected to said A/D converter (32) and said storage unit (34) and configured to obtain a secondary detection value of said potential transformer and a differential value of said detection value, and determine whether a trap voltage occurs according to said detection value, said differential value, and said indicator (Fprim).

7. The device as claimed in claim 6, wherein said calculation unit (36) is configured to
determine that said potential transformer starts to enter a trap state if said indicator (Fprim) is in the AC state, and both said detection value and said differential value are less than a preset first threshold (TH1);
determine that said potential transformer starts to recover from the trap state to the normal state if said indicator (Fprim) is in the DC state, and both said detection value and said differential value are greater than or equal to said preset first threshold (TH1).

8. The device as claimed in claim 6, wherein said storage unit (34) further stores a trap voltage counter (COUNTtrap) and a recovery counter (COUNTrecv);
said calculation unit (36) is further configured to
increment said trap voltage counter (COUNTtrap) by 1 if said indicator (Fprim) is in the AC state, and both said detection value and said differential value are less than a preset first threshold (TH1);
Increment said recovery counter (COUNTrecv) by 1 if said indicator (Fprim) is in the DC state, and both said detection value and said differential value are greater than or equal to said preset first threshold (TH1);
switch the state of said indicator (Fprim) from the AC state to the DC state if said trap voltage counter (COUNTtrap) is greater than a second threshold (TH2), which indicates that said potential transformer enters a trap voltage state;
switch the state of the indicator (Fprim) from the DC state to the AC state if said recovery counter (COUNTrecv) is greater than a third threshold (TH3), which indicates that the trap voltage state of said potential transformer ends.

9. The device as claimed in claim 8, wherein said second threshold (TH2) corresponds to about 1/4 to 3/4 of a cycle of said primary AC electrical signal.

10. The device as claimed in claim 8, wherein said third threshold (TH3) corresponds to about 1/80 to 1/2 of a cycle of said primary AC electrical signal.

## Patentansprüche

1. Verfahren zum Detektieren einer Sperrspannung eines Kondensatorpotentialtransformators, wobei der Potentialtransformator zwischen eine Primärausrüstung und eine Sekundärausrüstung geschaltet ist, wobei das Verfahren Folgendes umfasst:
Einstellen eines Ausgangszustands eines Kennzeichens (Fprim), wobei das Kennzeichen (Fprim) zwei Zustände aufweist, wovon einer angibt, dass eine Primärspannung eine Wechselspannung ist, und der andere angibt, dass die Primärspannung eine Gleichspannung ist;
Erhalten eines Detektionswertes auf der Sekundärseite des Potentialtransformators;
Erhalten eines Differentialwertes des Detektionswertes; und
Bestimmen, ob eine Sperrspannung auftritt, gemäß dem Detektionswert, dem Differentialwert und dem Kennzeichen (Fprim).

2. Verfahren nach Anspruch 1, wobei der Bestimmungsschritt Folgendes umfasst:
dann, wenn sich das Kennzeichen (Fprim) im Wechselspannungszustand befindet und sowohl der Detektionswert (Vin) als auch der Differentialwert kleiner als ein vorgegebener erster Schwellenwert (TH1) sind, Angeben, dass der Potentialtransformator beginnt, in einen Sperrzustand einzutreten;
dann, wenn sich das Kennzeichen (Fprim) im Gleichspannungszustand befindet und sowohl der Detektionswert als auch der Differentialwert größer oder gleich dem vorgegebenen ersten Schwellenwert (TH1) sind, Angeben, dass der Potentialtransformator beginnt, sich aus dem Sperrzustand in den regulären Zustand zu regenerieren.

3. Verfahren nach Anspruch 1, das ferner Folgendes umfasst:
Einstellen der Ausgangswerte eines Sperrspannungszählers (COUNTtrap) und eines Regenerierungszählers (COUNTrecv) auf 0;
wobei der Bestimmungsschritt Folgendes umfasst:
dann, wenn sich das Kennzeichen (Fprim) im Wechselspannungszustand befindet und sowohl der Detektionswert als auch der Differentialwert kleiner als ein vorgegebener erster Schwellenwert (TH1) sind, Inkrementieren des Sperrspannungszählers (COUNTtrap) um 1;
dann, wenn sich das Kennzeichen (Fprim) im Gleichspannungszustand befindet und sowohl der Detektionswert (Vin) als auch der Differentialwert größer oder gleich dem vorgegebenen ersten Schwellenwert (TH1) sind, Inkrementieren des Regenerierungszählers (COUNTrecv) um 1;
dann, wenn der Sperrspannungszähler (COUNTtrap) größer als ein zweiter Schwellenwert (TH2) ist, der angibt, dass der Potentialtransformator in einen Sperrspannungszustand eintritt, Umschalten des Zustands des Kennzeichens (Fprim) vom Wechselspannungszustand in den Gleichspannungszustand;
dann, wenn der Regenerierungszähler (COUNTrecv) größer als ein dritter Schwellenwert (TH3) ist, der angibt, dass der Sperrspannungszustand des Potentialtransformators endet, Umschalten des Zustands des Kennzeichens (Fprim) vom Gleichspannungszustand in den Wechselspannungszustand.

4. Verfahren nach Anspruch 3, wobei der zweite Schwellenwert (TH2) etwa 1/4 bis 3/4 eines Zyklus des primären elektrischen Wechselspannungssignals entspricht.

5. Verfahren nach Anspruch 3, wobei der dritte Schwellenwert (TH3) etwa 1/80 bis 1/2 eines Zyklus des primären elektrischen Wechselspannungssignals entspricht.

6. Vorrichtung (30) zum Detektieren einer Sperrspannung eines Kondensatorpotentialtransformators, wobei die Vorrichtung (30) Folgendes umfasst:
Eingangsenden (M und N), die mit den Ausgangsenden (C und D) auf der Sekundärseite des Potentialtransformators verbunden sind;
einen Analog/Digital-Umsetzer (A/D-Umsetzer) (32), der die Signale, die von den Eingangsenden (M und N) eingegeben werden, abtastet, um einen Detektionswert auf der Sekundärseite des Potentialtransformators zu erhalten;
eine Speichereinheit (34), die ein Kennzeichen (Fprim) speichert, wobei das Kennzeichen (Fprim) zwei Zustände aufweist, wovon einer angibt, dass eine Primärspannung des Potentialtransformators eine Wechselspannung ist, und der andere angibt, dass die Primärspannung des Potentialtransformators eine Gleichspannung ist;
eine Berechnungseinheit (36), die mit dem A/D-Umsetzer (32) und der Speichereinheit (34) verbunden und konfiguriert ist, einen Sekundärdetektionswert des Potentialtransformators und einen Differentialwert des Detektionswertes zu erhalten und gemäß dem Detektionswert, dem Differentialwert und dem Kennzeichen (Fprim) zu bestimmen, ob eine Sperrspannung auftritt.

7. Vorrichtung nach Anspruch 6, wobei die Berechnungseinheit (36) konfiguriert ist zum:
Bestimmen, dass der Potentialtransformator beginnt, in einen Sperrzustand einzutreten, wenn sich das Kennzeichen (Fprim) im Wechselspannungszustand befindet und sowohl der Detektionswert als auch der Differentialwert kleiner als ein vorgegebener erster Schwellenwert (TH1) sind;
Bestimmen, dass der Potentialtransformator beginnt, sich aus dem Sperrzustand in den regulären Zustand zu regenerieren, wenn sich das Kennzeichen (Fprim) im Gleichspannungszustand befindet und sowohl der Detektionswert als auch der Differentialwert größer oder gleich dem vorgegebenen ersten Schwellenwert (TH1) sind.

8. Vorrichtung nach Anspruch 6, wobei die Speichereinheit (34) ferner einen Sperrspannungszähler (COUNTtrap) und einen Regenerierungszähler (COUNTrecv) speichert;
wobei die Berechnungseinheit (36) ferner konfiguriert ist zum:
Inkrementieren des Sperrspannungszählers (COUNTtrap) um 1, wenn sich das Kennzeichen (Fprim) im Wechselspannungszustand befindet und sowohl der Detektionswert als auch der Differentialwert kleiner als ein vorgegebener erster Schwellenwert (TH1) sind;
Inkrementieren des Regenerierungszählers (COUNTrecv) um 1, wenn sich das Kennzeichen (Fprim) im Gleichspannungszustand befindet und sowohl der Detektionswert als auch der Differentialwert größer oder gleich dem vorgegebenen ersten Schwellenwert (TH1) sind;
Umschalten des Zustands des Kennzeichens (Fprim) vom Wechselspannungszustand in den Gleichspannungszustand, wenn der Sperrspannungszähler (COUNTtrap) größer als ein zweiter Schwellenwert (TH2) ist, der angibt, dass der Potentialtransformator in einen Sperrspannungszustand eintritt;
Umschalten des Zustands des Kennzeichens (Fprim) vom Gleichspannungszustand in den Wechselspannungszustand, wenn der Regenerierungszähler (COUNTrecv) größer als ein dritter Schwellenwert ist, der angibt, dass der Sperrspannungszustand des Potentialtransformators endet.

9. Vorrichtung nach Anspruch 8, wobei der zweite Schwellenwert (TH2) etwa 1/4 bis 3/4 eines Zyklus des primären elektrischen Wechselspannungssignals entspricht.

10. Vorrichtung nach Anspruch 8, wobei der dritte Schwellenwert (TH3) etwa 1/80 bis 1/2 eines Zyklus des primären elektrischen Wechselspannungssignals entspricht.

## Revendications

1. Procédé de détection d'une tension piège d'un transformateur de potentiel de condensateur, ledit transformateur de potentiel étant connecté entre un équipement primaire et un équipement secondaire, ledit procédé comprenant :
le réglage d'un état initial d'un indicateur (Fprim), ledit indicateur (Fprim) ayant deux états, l'un qui indique qu'une tension primaire est une tension AC, et l'autre qui indique que ladite tension primaire est une tension DC ;
l'obtention d'une valeur de détection du côté secondaire dudit transformateur de potentiel ;
l'obtention d'une valeur différentielle de ladite valeur de détection ;
la détermination de la survenue ou non d'une tension piège en fonction de ladite valeur de détection, de ladite valeur différentielle, et dudit indicateur (Fprim).

2. Procédé selon la revendication 1, ladite étate de détermination comprenant :
si ledit indicateur (Fprim) est dans l'état AC, et ladite valeur de détection (Vin) et ladite valeur différentielle sont toutes les deux inférieures à un premier seuil préréglé (TH1), l'indication que ledit transformateur de potentiel commence à entrer en un état piège ;
si ledit indicateur (Fprim) est dans l'état DC, et ladite valeur de détection et ladite valeur différentielle sont toutes les deux supérieures ou égales audit premier seuil prédéfini (TH1), l'indication que ledit transformateur de potentiel commence à se rétablir d'un état piège vers un état normal.

3. Procédé selon la revendication 1, comprenant en outre :
le réglage des valeurs initiales du compteur de tension piège (COUNTtrap) et un compteur de rétablissement (COUNTrecv) à 0 ; ladite étape de détermination comprenant :
si ledit indicateur (Fprim) est dans l'état AC, et ladite valeur de détection et ladite valeur différentielle sont toutes les deux inférieures à un premier seuil préréglé (TH1), l'incrémentation dudit compteur de tension piège (COUNTtrap) de 1 ;
si ledit indicateur (Fprim) est dans l'état DC, et ladite valeur de détection (Vin) et ladite valeur différentielle sont toutes les deux supérieures ou égales audit premier seuil prédéfini (TH1), l'incrémentation dudit compteur de rétablissement (COUNTrecv) de 1 ;
si ledit compteur de tension piège (COUNTtrap) est supérieur à un deuxième seuil (TH2), qui indique que le transformateur de potentiel entre en un état de tension piège, la commutation de l'état de l'indicateur (Fprim) d'un état AC à un état DC ;
si ledit compteur de rétablissement (COUNTrecv) est supérieur à un troisième seuil (TH3), qui indique que l'état de tension piège du transformateur de potentiel prend fin, la commutation de l'état de l'indicateur (Fprim) d'un état DC à un état AC.

4. Procédé selon la revendication 3, ledit deuxième seuil (TH2) correspondant à environ 1/4 à 3/4 d'un cycle dudit signal électrique AC primaire.

5. Procédé selon la revendication 3, ledit troisième seuil (TH3) correspondant à environ 1/80 à 1/2 d'un cycle dudit signal électrique AC primaire.

6. Dispositif (30) de détection d'une tension piège d'un transformateur de potentiel de condensateur, le dispositif (30) comprenant :
des extrémités d'entrée (M et N), connectées aux extrémités de sortie (C et D) du côté secondaire dudit transformateur de potentiel ;
un convertisseur (32) analogique/numérique (A/D), échantillonnant l'entrée de signaux provenant desdites extrémités d'entrée (M et N) pour obtenir une valeur de détection du côté secondaire dudit transformateur de potentiel ;
une unité de stockage (34), stockant un indicateur (Fprim), ledit indicateur (Fprim) ayant deux états, l'un qui indique qu'une tension primaire dudit transformateur de potentiel est une tension AC, et l'autre qui indique que ladite tension primaire dudit transformateur de potentiel est une tension DC ;
une unité de calcul (36), connectée audit convertisseur A/D (32) et à ladite unité de stockage (34) et configurée pour obtenir une valeur de détection secondaire dudit transformateur de potentiel et une valeur différentielle de ladite valeur de détection, et déterminer si une tension piège survient en fonction de ladite valeur de détection, ladite valeur différentielle, et ledit indicateur (Fprim).

7. Dispositif selon la revendication 6, ladite unité de calcul (36) étant configurée pour
déterminer que ledit transformateur de potentiel commence à entrer en un état piège si ledit indicateur (Fprim) est dans l'état AC, et ladite valeur de détection et ladite valeur différentielle sont toutes les deux inférieures à un premier seuil préréglé (TH1) ;
déterminer que ledit transformateur de potentiel commence à se rétablir d'un état piège vers un état normalsi ledit indicateur (Fprim) est dans l'état DC, et ladite valeur de détection et ladite valeur différentielle sont toutes les deux supérieures ou égales audit premier seuil prédéfini (TH1).

8. Dispositif selon la revendication 6, ladite unité de stockage (34) stockant en outre un compteur de tension piège (COUNTtrap) et un compteur de rétablissement (COUNTrecv) ;
ladite unité de calcul (36) étant en outre configurée pout
incrémenter ledit compteur de tension piège (COUNTtrap) de 1si ledit indicateur (Fprim) est dans l'état AC, et ladite valeur de détection et ladite valeur différentielle sont toutes les deux inférieures à un premier seuil préréglé (TH1) ;
incrémenter ledit compteur de rétablissement (COUNTrecv) de 1si ledit indicateur (Fprim) est dans l'état DC, et ladite valeur de détection et ladite valeur différentielle sont toutes les deux supérieures ou égales audit premier seuil prédéfini (TH1) ;
commuter l'état dudit indicateur (Fprim) d'un état AC à un état DC si ledit compteur de tension piège (COUNTtrap) est supérieur à un deuxième seuil (TH2), qui indique que ledit transformateur de potentiel entre en un état de tension piège ;
commuter l'état de l'indicateur (Fprim) d'un état DC à un état AC si ledit compteur de rétablissement (COUNTrecv) est supérieur à un troisième seuil (TH3), qui indique que l'état de tension piège dudit transformateur de potentiel prend fin.

9. Dispositif selon la revendication 8, ledit deuxième seuil (TH2) correspondant à environ 1/4 à 3/4 d'un cycle dudit signal électrique AC primaire.

10. Procédé selon la revendication 8, ledit troisième seuil (TH3) correspondant à environ 1/80 à 1/2 d'un cycle dudit signal électrique AC primaire.
